## Europäisches Patentamt

## European Patent Office

## Office européen des brevets

(19)

Veröffentlichungsnummer: **0 010 240**

**A1**

(12)

## EUROPÄISCHE PATENTANMELDUNG

(21) Anmeldenummer: **79103824.3**

(22) Anmeldetag: **06.10.79**

(51) Int. Cl.³: **G 01 K 13/00**
**G 01 K 7/24**

(30) Priorität: **12.10.78 DE 2844416**

(43) Veröffentlichungstag der Anmeldung:
**30.04.80 Patentblatt 80/9**

(84) Benannte Vertragsstaaten:
**AT BE CH DE FR GB IT LU NL SE**

(71) Anmelder: **CLINICON INTERNATIONAL GMBH**
**Sandhofer Strasse 176**
**D-6800 Mannheim 31(DE)**

(72) Erfinder: **Thiery, Joachim, Dr.**
**Dornheimer Ring 6**
**D-6800 Mannheim 31(DE)**

(72) Erfinder: **Rebbe, Klaus**
**Bodelschwinghweg 23**
**D-6800 Mannheim 31(DE)**

(74) Vertreter: **Daum, Martin, Dr. et al,**
**Boehringer Mannheim GmbH. Sandhoferstrasse 116**
**D-6800 Mannheim 31(DE)**

(54) **Fieberthermometer.**

(57) Die Erfindung betrifft ein Fieberthermometer mit einem mechanisch veränderbaren elektrischen Bauelement (21) und einer damit verbundenen Anzeigeeinheit (12) Weiter schließt sie eine elektrische Schaltung ein (20), die zum Abgleichen von Signalen des mechanisch veränderbaren Bauelementes mit den Signalen eines temperaturabhängigen Bauelementes (14) und zum Erzeugen von Steuersignalen dient. Die mit den bekannten elektronischen Fieberthermometern verbundenen Nachteile, z B. Driften und hoher Energieverbrauch, werden erfindungsgemäß dadurch vermieden, daß die Anzeigeeinheit mit einem vorspannbaren und auslösbaren mechanischen Triebwerk (10) verbunden ist und eine Bewegungsunterbrechungsvorrichtung (13) vorgesehen ist, die bei Abgleich auf ein Steuersignal der elektrischen Schaltung (20) hin die Bewegung der Anzeigeeinheit (12) unterbricht.

Fig.1

CLINICON INTERNATIONAL GMBH   201 0010240

## Fieberthermometer

Die Erfindung betrifft ein Fieberthermometer mit einem
mechanisch veränderbaren elektrischen Bauelement und einer
damit verbundenen Anzeigeeinheit und mit einer elektrischen
Schaltung zum Abgleichen von Signalen des mechanisch veränderbaren Bauelements mit den Signalen eines temperaturabhängigen
Bauelements und zum Erzeugen von Steuersignalen.

Es wurden bereits derartige Thermometer beschrieben (US-PS 3 469 449), in denen der Spannungsabfall an einem
mechanisch bewegten Potentiometer mit dem Spannungsabfall an einem Widerstand eines temperaturempfindlichen Bauelementes verglichen wird
und in Abgleichstellung auf einer Skala
die gemessene Temperatur ablesbar ist.

Gegenüber vollelektronischen Fieberthermometern hat ein solches
Thermometer den Vorteil, daß Fehlanzeigen durch normales Verändern (z.B. Driften) der elektronischen Bauelemente vermieden
werden, weil mechanisch ein eindeutiger Referenzwert vorliegt.

Die bekannten Thermometer sind jedoch relativ kompliziert zu
bedienen, weil ein Handabgleich der beiden Spannungssignale
nötig ist. Bei Verwendung eines Motorantriebes hierfür ergibt
sich der Nachteil, daß der Motorantrieb relativ viel Energie
verbraucht, die bei netzunabhängigen Geräten von Batterien
entnommen wird, die sich demnach sehr schnell verbrauchen.

Der Erfindung liegt daher die Aufgabe zugrunde, ein netzunabhängiges Thermometer zu schaffen, das mit wenig gespeicherter
elektrischer Energie auskommt.

Diese Aufgabe wird bei dem eingangs genannten Thermometer dadurch gelöst, daß das Anzeigeinstrument mit einem vorspannbaren
und auslösbaren mechanischen Triebwerk verbunden ist und eine
Bewegungsunterbrechungseinrichtung vorgesehen ist, die bei Abgleich auf ein Steuersignal der elektrischen Schaltung hin die Bewegung der Anzeigeeinheit unterbricht.

Für das Triebwerk wird vorzugsweise eine spiralförmig vorgespannte Feder verwendet. Bei den (bisherigen) Quecksilber-Fieberthermometern war man gewohnt, vor einer Messung die Quecksilbersäule in eine Ausgangsstellung zurückzuschütteln. Dies wird bei einem Gerät der Erfindung dadurch ersetzt, daß das Triebwerk vor einer Messung von Hand vorgespannt wird. Danach kann das Triebwerk ausgelöst werden und läuft ab, bis bei Abgleich auf ein Steuersignal der elektrischen Vergleichsschaltung hin die Bewegung der Anzeigeeinheit von einer Bewegungsunterbrechungseinrichtung unterbrochen wird.

In vorteilhafter Weiterentwicklung der Erfindung ist die Verbindung des Triebwerkes elektromechanisch von einem als Anzeigeeinheit verwendeten Zählwerk auskoppelbar, so daß das mitlaufende Zählwerk in dem Augenblick stehen bleibt, in dem die Abgleichstellung erreicht wird.

Eine weitere vorteilhafte Ausgestaltung der Erfindung wird darin gesehen, daß das Triebwerk so ausgestaltet ist, daß gleichzeitig ausreichend elektrische Energie für die Schaltung geliefert wird. Dazu kann mit dem Triebwerk ein Dynamo verbunden sein.

Eine Nacheichung des Gerätes der Erfindung ist deshalb praktisch nicht erforderlich, weil eine starre mechanische Verbindung zwischen Zählwerk und Antrieb im Bereich üblicher Fertigungstoleranzen herstellbar ist, die sich über längere Zeit nicht verändert.

Die Erfindung wird nun anhand eines in der Zeichnung dargestellten Ausführungsbeispieles näher erläutert.

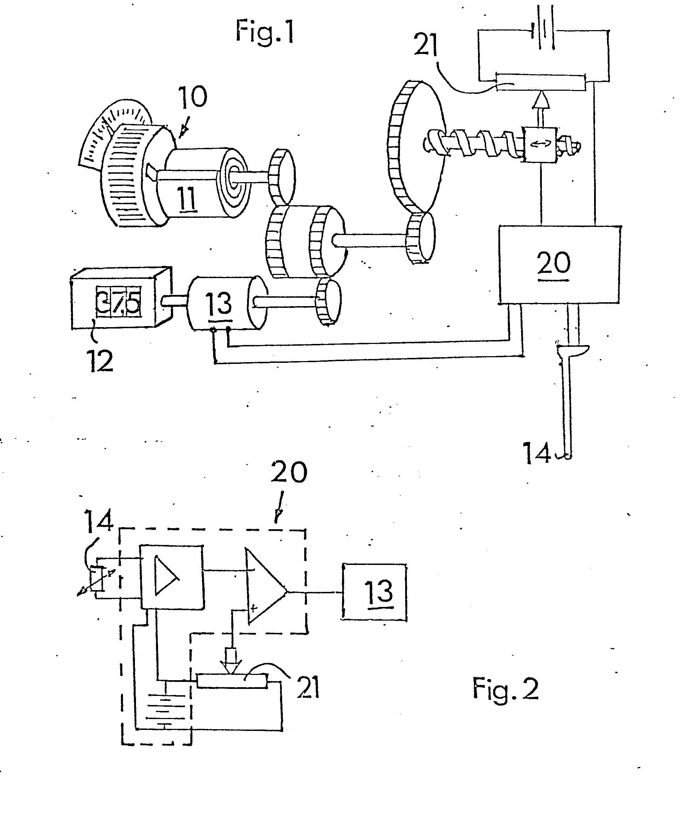

Es zeigen Fig. 1 ein Fieberthermometer ohne Gehäuse;
Fig. 2 ein Prinzipschaltbild der elektrischen Schaltung für ein
Fieberthermometer nach Fig. 1.

In Fig. 1 ist ein, einem Uhrwerk ähnliches, Antriebssystem 10 für ein Fieberthermometer dargestellt, das mit Zahnrädern ausgerüstet ist, die eine starre Verbindung mit einem vorgegebenen Übersetzungsverhältnis zwischen dem das mechanisch veränderbare elektrische Bauteil bildenden Potentiometer 21 und einem Zählwerk 12 bilden. Das Zählwerk 12 und das Potentiometer 21 werden gemeinsam von einem Antrieb bewegt, der von einem Triebwerk 10 einen Drehimpuls erhält, der von den Spannkräften einer spiralförmigen Blattfeder 11 resultiert, mit der das Triebwerk vorspannbar ist. Statt des Zählwerkes 12 kann auch eine Analoganzeige vorgesehen sein, wie sie beispielhaft beim Triebwerk 10 angedeutet ist.

Vorzugsweise ist in dem Zahnradwerk eine geeignete Bremse derart eingebaut, daß bei einer Messung eine gleichmäßige Umdrehungsgeschwindigkeit der Zahnräder bei verschieden starken Vorspannungen (Drehmomenten) der spiralförmig aufgewickelten Blattfeder erreicht wird.

Mit dem Potentiometer 21 verbunden ist eine elektrische Schaltung 20, deren Funktion in Fig. 2 näher erläutert ist. Die Bauelemente dieser Schaltung können auf der gleichen Unterlage angebracht sein, auf der das Potentiometer 21 angeordnet ist und von der Anschlüsse zum Meßfühler 10, z.B. einem NTC-Widerstand, ausgehen.

Nach Vorspannen der Blattfeder 11 des Triebwerkes 10 und Auslösen des Bewegungsvorgangs ändert sich durch die Bewegung des Schleifers des Potentiometers 21 die daran anliegende Spannung.

Die elektrische Schaltung vergleicht diese Spannung mit der des Meßfühlers 14 und gibt bei Abgleich ein Steuersignal an die Bewegungsunterbrechungseinrichtung 13. Dadurch wird die Bewegung des Zählers 12 unterbrochen, so daß nach Messung ein Zählerstand bleibt, der dem gemessenen Temperaturwert entspricht. Sollte es nicht ausreichen, daß ein evtl. meßbarer Nachlauffehler wegen Trägheit der Stoppeinrichtung beseitigt wird, dann ist eine (nicht dargestellte) Doppelanordnung des Triebwerkes und des Antriebes vorgesehen, die in entgegengesetzter Drehrichtung läuft und zwei Temperaturgrenzwerte liefert, deren Mittelwert frei von Nachlauffehlern ist.

Sollte das Triebwerk 10 nicht in der Lage sein, auch noch ausreichend Energie zur Versorgung der elektrischen Schaltung 20 zu liefern, so ist es möglich, daß der für die Schaltung sehr geringe Energiebedarf von einer zusätzlichen Stromquelle gedeckt wird.

Bei Kopplung des Triebwerkes 10 mit einem stromerzeugenden Bauelement, beispielsweise einem Dynamo, ist es aber auch möglich, ein Fieberthermometer zu schaffen, das ganz ohne elektrischen Energiespeicher, z.B. Batterie, auskommt, weil die Energie für die elektrische Schaltung 20 dann durch den Antrieb mitgeliefert wird.

Es ist vorgesehen, daß das Triebwerk für jede Messung neu vorgespannt wird. Außer Energieerzeugung wird beim Vorspannen das Zählwerk 12 auf eine Null-Stellung eingestellt, so daß das Fieberthermometer wie ein Quecksilberthermometer zu Handhaben ist (das auch vor jeder Messung mechanisch in eine Ausgangsstellung zu bringen ist.)

Es ist bekannt, daß NTC-Widerstände zuverlässig genau Temperaturänderungen registrieren. Ohne den bekannten großen elektronischen Aufwand vollelektronischer Geräte mit sehr schwierig beeinflußbaren Eichfehlern, die beim Verändern der elektronischen Bauelemente, z.B. durch sogenanntes Driften entstehen, liefert das Thermometer der Erfindung schnelle und genaue Werte. Gegenüber Fieberthermometern mit elektronischer Temperaturanzeige hat die Erfindung außerdem noch den Vorteil, daß ein mechanisches Zählwerk verwendbar ist, das den zuletzt gemessenen Temperaturwert ohne Energiezufuhr lange Zeit speichert.

Es wird darauf hingewiesen, daß die Proportionen des dargestellten Thermometers nicht der Wirklichkeit entsprechen, sondern nur das Erfindungswesentliche besser herausstellen sollen. In der Praxis sind relativ kleine Antriebe mit Federtriebwerk etwa in Größenordnung des zu verwendenden veränderbaren Bauelementes vorgesehen.

Zur Auswertung selbst ist natürlich jede Brückenschaltung geeignet, die hinreichend genaue Vergleichswerte wie die in Fig. 2 dargestellte Schaltung 20 liefert.

Die Erfindung läßt sich auch auf andere Temperaturmeßgeräte ausdehnen, die möglichst ohne Batterie auskommen und hinreichend genaue Meßwerte in einem engen Meßbereich liefern sollen.

001024C

Bezugszeichen

10 Triebwerk
11 spiralförmige Blattfeder
12 Anzeigeeinheit (Zählwerk)
13 Bewegungsunterbrechungsvorrichtung
14 Meßfühler
20 elektrische Schaltung
21 Potentiometer

Die in Figur 1 bis 4 dargestellten Montageblöcke können auf normalen Produktionsmaschinen für Hohlblöcke hergestellt werden, wobei die horizontale Aussparung 1 durch einen Formenkern und die Aussparung 2 durch Ziehen eines Schwertes hergestellt wird. Der Kern und das Schwert sind entsprechend der beschriebenen Form der Aussparungen zur Mitte des Steines hin leicht konisch. Gleichzeitig können auch die erwähnten Wülste 3 gebildet werden. Die beschriebene Anordnung der Aussparungen 1,2 bzw. der durchgehenden Isolierplatten 4 erlaubt ferner die Verwendung von Steinproduktionsmaschinen, welche wie z.B. in der Ziegelindustrie im Strangverfahren arbeiten. Der Montageblock kann aus einem gelochten Steinmaterial auf einer Strangpresse hergestellt werden, wie es in Figur 8 dargestellt ist, wobei die über den gesamten Steinquerschnitt verteilten Löcher eine noch bessere Wärmeisolierung gewährleisten, da der "Kältestrom" noch weiter abgeleitet bzw. unterbrochen wird. Für die Aufnahme des Lagerfugenmörtels kann bei der Produktion mit einer Beschwerdeplatte ein Mörtelbett 6 eingedrückt und eingerüttelt werden. Die hierbei stehenbleibenden Stege 7 können zunächst auf eine die gewünschte Steinhöhe überschreitende Höhe produziert und nach der Erhärtung des Montageblockes mit einer speziellen Fräsmaschine (z.B. gemäß DE-PS 1 427 712) planparallel bearbeitet und um einige Millimeter abgefräst werden.

Vorzugsweise werden die Montageblöcke jedoch ohne Fräsen in der weiter unten anhand von Fig. 9-13 näher erläuterten Weise hergestellt. Darüberhinaus ist die Erfindung auch auf Montageblöcke anwendbar, die ohne extrem genaue Höhentoleranzen der Stege 7 und der Auflagerflächen im Bereich 10 hergestellt werden. Steinhöhentoleranzen werden dann durch Auftrag von Lagerfugenmörtel in entsprechender Stärke ausgeglichen, was allerdings die Verwendung von Schnur und Wasserwaage bei jeder verlegten Schicht erforderlich macht. Die besondere Isolierwirkung durch die Platten 4 bleibt auch in diesem Fall im wesentlichen erhalten; lediglich im Bereich der Lagerfugen könnten durch die Steinhöhenabweichungen kleinere Mörtelflächen sichtbar werden.

Zur Gewichtserleichterung und als Griffloch, welches das Verlegen des Montageblockes erleichtert, befindet sich in der Unter- oder Oberseite des Steines eine Längsaussparung 11. Die Längsaussparung 11 dient zugleich zur Aufnahme von gegebenenfalls zu viel eingefülltem Mörtel der Lagerfuge, d.h. des Mörtelbettes 6. Ferner erhält der Montageblock an den vier Ecken in den Stoßfugen Ausnehmungen 12 zur Aufnahme des Stoßfugenmörtel. Die Tiefe dieser Ausnehmungen 12 ist so bemessen, daß überflüssiger Lagerfugenmörtel aus dem Mörtelbett 6 nach unten entweichen kann.

In Figur 4 ist ein Montageblock dargestellt, der zusätzlich zu den bereits beschriebenen Merkmalen mehrere Trennuten 13 aufweist. Die Trennuten erleichtern ein Sägen oder Schlagen des Blockes am Bau, wenn man Sondersteine benötigt, z.B. solche mit vertikalen Schlitzen 19 gemäß Figur 7 oder Steine für Wandeinbindungen gemäß Figur 5 und 6. Bei einer Wandeinbindung kann ein herausgesägtes Isolierplattenstück 14 seitlich wieder eingesetzt werden, so daß die Wärmeisolierung nicht unterbrochen wird.

Wie schon erwähnt wurde, können die Isolierplatten 4 gemäß Figur 3 und 4 horizontal entsprechend den Bedürfnissen am Bau verschoben werden, wie durch den Pfeil 15 angedeutet ist. Dies steht im Gegensatz zu bekannten Montageblöcken, die in ihren Aussparungen Querstege zur Halterung der äußeren Steinschale aufweisen und dadurch die Isoliereinlagen festhalten, und zu solchen Blöcken, deren Isoliereinlagen aus nicht ohne weiteres herausnehmbaren Füllungen bestehen. Bei Verwendung der hier beschriebenen Montageblöcke können diese z.B. bei Errichtung einer Wand mit ungenormter Länge seitlich so gezogen werden, daß zwischen den einzelnen Blöcken größere Abstände entstehen, wie in Figur 3 bei 16 dargestellt ist. Auch in diesem Fall werden beide Isolierplatten 4 so vorgezogen, daß sie in den nächsten Block eingreifen und somit die Stoßfuge unter hoher Wärmedämmwirkung abdichten. Eine andere Möglichkeit besteht darin, am Mauerende oder an der Maueröffnung für ein Fenster oder eine Türe die Isolierplatte 4 so vorzuziehen, daß sie eine Abdichtung und gleichzeitige Isolierung z.B. der Fensteroder Türrahmen gewährleistet, wie in Figur 5 bei 17 dargestellt ist.

Ansprüche

1. Fieberthermometer mit einem mechanisch veränderbaren elektrischen Bauelement und einer damit verbundenen Anzeigeeinheit und mit einer elektrischen Schaltung zum Abgleichen von Signalen des mechanisch veränderbaren Bauelementes mit den Signalen eines temperaturabhängigen Bauelementes und zum Erzeugen von Steuersignalen, dadurch gekennzeichnet, daß die Anzeigeeinheit (12) mit einem vorspannbaren und auslösbaren mechanischen Triebwerk (10) verbundenen ist und eine Bewegungsunterbrechungsvorrichtung (13) vorgesehen ist, die bei Abgleich auf ein Steuersignal der elektrischen Schaltung (20) hin die Bewegung der Anzeigeeinheit (12) unterbricht.

2. Fieberthermometer nach Anspruch 1, dadurch gekennzeichnet, daß das Triebwerk (10) eine spiralförmig vorspannbare Blattfeder (11) enthält, deren Spannkraft auf ein Rad des Antriebes übertragen wird, das in einer Drehrichtung mit vorgebbarer Geschwindigkeit bewegbar ist.

3. Fieberthermometer nach Anspruch 1 oder 2, dadurch gekennzeichnet, daß von einem für jede Messung neu vorzuspannenden Triebwerk (10) außerdem Energie zur Versorgung der elektrischen Schaltung (20) geliefert wird.

4. Fieberthermometer nach Anspruch 3, dadurch gekennzeichnet, daß das Triebwerk (10) mit einem Dynamo verbunden ist.

001024C

5. Fieberthermometer nach einem der vorhergehenden Ansprüche, dadurch gekennzeichnet, daß das veränderbare Bauelement ein Potentiometer (21) ist, das mit einem auf eine Ausgangsstellung rückstellbaren Zählwerk (12) verbunden ist und daß als Meßfühler (14) ein NTC-Widerstand vorgesehen ist.

6. Fieberthermometer nach einem der vorhergehenden Ansprüche, dadurch gekennzeichnet, daß ein Paar von in Antriebsrichtung entgegengesetzt angekoppelten Triebwerken (10) vorgesehen ist, die durch nacheinander ausgelöste Messung zwei auf einen Mittelwert umrechenbare Endwerte liefern.

# Fig.1

# Fig. 2

# EUROPÄISCHER RECHERCHENBERICHT

001024C

EP 79 10 3824

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | CH - A - 501 905 (TEST S.A.)  *Einführung; Spalte 2, Zeile 40 bis Spalte 3; Spalte 4 - Spalte 5, Zeile 32; Figuren 1-7 * | 1,2,5 |
| | -- | |
| | US - A - 3 604 266 (G.E. CHILTON)  *Einführung; Spalte 3, Zeile 24 bis Spalte 4, Zeile 33; Spalte 4, Zeile 62 bis Spalte 5, Zeile 9; Figuren 4-6,10 * | 1,2,5 |
| | -- | |
| P | DE - A - 2 724 930 (H. GROSS)  *Einführung; Seiten 10,11; Seite 12, Spalten 1,2; Seite 13, Spalten 4,5; Seite 16, Spalte 3; Figuren 1,2,11 * | 1,2,5 |
| | -- | |
| A | US - A - 4 117 723 (R. MARAVICH)  *Einführung; gesamtes Patentschrift * | 1 |
| | -- | |
| A | DE - A - 2 532 610 (H. HURLIMANN)  *Einführung; gesamtes Patentschrift * | 1 |
| | -- | |
| A | FR - A - 2 206 503 (SOCIETE TEST)  *Gesamtes Patentschrift * | 1,5 |
| | -- | |
| A | US - A - 3 545 273 (V.P. FRIBERG et. al.)  ./. | 1,2,5 |

### KLASSIFIKATION DER ANMELDUNG (Int.Cl. 3)

G 01 K 13/00  
7/24

### RECHERCHIERTE SACHGEBIETE (Int. Cl. 3)

G 01 K 13/00  
7/24  
1/02

### KATEGORIE DER GENANNTEN DOKUMENTE

X: von besonderer Bedeutung  
A: technologischer Hintergrund  
O: nichtschriftliche Offenbarung  
P: Zwischenliteratur  
T: der Erfindung zugrunde liegende Theorien oder Grundsätze  
E: kollidierende Anmeldung  
D: in der Anmeldung angeführtes Dokument  
L: aus andern Gründen angeführtes Dokument  
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 17-01-1980 | VISSER |

EPA form 1503.1   06.78

Europäisches
Patentamt

EUROPÄISCHER RECHERCHENBERICHT

0010240

Nummer der Anmeldung

EP 79 10 3824
-2-

| | EINSCHLÄGIGE DOKUMENTE | | KLASSIFIKATION DER ANMELDUNG (Int.Cl. 3) |
|---|---|---|---|
| Kategorie | Kennzeichnung des Dokuments mit Angabe, soweit erforderlich, der maßgeblichen Teile | betrifft Anspruch | |
| | * Einführung; gesamtes Patentschrift * ---- | | |
| | | | **RECHERCHIERTE SACHGEBIETE (Int. Cl. 3)** |